# FASCICULE DE BREVET EUROPEEN

(11) **EP 3 840 200 B1**
(45) Date de publication et mention de la délivrance du brevet: **11.10.2023**
(21) Numéro de dépôt: 20210507.8
(22) Date de dépôt: 30.11.2020
(51) Int. Cl.: H03K 17/16

(54) **VERROUILLAGE DE COMMANDE D'UN INTERRUPTEUR**
SCHALTERSTEUERUNGSSPERRE
LOCKING SYSTEM FOR CONTROLLING A SWITCH

(30) Priorité: 19.12.2019 FR 1914876
(43) Date de publication de la demande: 23.06.2021
(73) Titulaire: Commissariat à l'Energie Atomique et aux Energies Alternatives, 75015 Paris (FR)
(72) Inventeur: LEFEVRE, Guillaume, 38054 GRENOBLE CEDEX 9 (FR); PEREZ, Gaëtan, 38054 GRENOBLE CEDEX 9 (FR); PIQUET-BOISSON, Guillaume, 38054 GRENOBLE CEDEX 9 (FR)
(74) Mandataire: Cabinet Beaumont

(56) Documents cités:
- WO-A1-2012/165649
- US-A1- 2012 086 496
- US-A1- 2013 200 929
- US-A1- 2016 191 047

## Description

### Domaine technique

La présente description concerne de façon générale les dispositifs électroniques, et plus particulièrement les convertisseurs à découpage.

### Technique antérieure

Les convertisseurs à découpage utilisent un ou des interrupteurs mis alternativement aux états passant et bloqué à une fréquence de découpage. On utilise des convertisseurs à découpage pour fournir une tension et/ou un courant à partir d'une alimentation ayant des valeurs de tension/courant différentes des valeurs des tension/courant à fournir. L'alimentation peut être une source de tension/courant continue, telle qu'une batterie ou un capteur photovoltaïque, ou alternative, telle qu'un alternateur. Dans certaines applications, le convertisseur est un onduleur fournissant la tension/courant sous forme alternative typiquement triphasée, par exemple à un moteur ou à un réseau de distribution d'électricité.

Un procédé de commande d'interrupteur selon le préambule de la revendication 1 est connu du document US 2012/0086496 A1.

### Résumé de l'invention

Il existe un besoin d'améliorer le rendement et la fiabilité des convertisseurs existants, en particulier, des onduleurs existants.

Un mode de réalisation pallie tout ou partie des inconvénients des procédés connus de commande d'un interrupteur.

Un mode de réalisation pallie tout ou partie des inconvénients des dispositifs de commande d'interrupteur.

Un mode de réalisation pallie tout ou partie des inconvénients des convertisseurs connus, en particulier des onduleurs connus.

Un mode de réalisation prévoit un procédé de commande d'un interrupteur, comprenant :
a) une application d'une commande à une borne de commande de l'interrupteur, ladite commande présentant au moins une première commutation entre un état de commande de fermeture de l'interrupteur et un état de commande d'ouverture de l'interrupteur, l'interrupteur passant à un état bloqué en un temps d'ouverture à partir de la première commutation ; et
b) une application d'un potentiel de blocage de l'interrupteur sur ladite borne de commande après un premier délai débutant à ladite première commutation, le premier délai étant supérieur au temps d'ouverture dans lequel :
   - la première commutation marque le début d'une première période à laquelle ladite commande est uniquement à l'état de commande d'ouverture ;
   - une deuxième période comprend des alternances des états de commande d'ouverture et de fermeture de l'interrupteur (T) ;
   - le premier délai est supérieur à un temps de cycle des alternances.

Selon un mode de réalisation, la première commutation constitue un front entre un niveau de fermeture et un niveau d'ouverture.

Selon un mode de réalisation, le premier délai est inférieur à 1 % d'une durée de la première période, de préférence inférieur à 0,2 % d'une durée de la première période, plus préférentiellement inférieur à 0,05 % de la première période.

Selon un mode de réalisation :
- ladite commande présente, lors de ladite application du potentiel de blocage, au moins une deuxième commutation entre l'état de commande d'ouverture et l'état de commande de fermeture ; et
- ladite application du potentiel de blocage est interrompue dans un deuxième délai débutant à ladite deuxième commutation et inférieur au premier délai, le deuxième délai étant de préférence inférieur à environ 1 ps.

Selon un mode de réalisation :
- ladite commande présente, en dehors de ladite application du potentiel de blocage, une troisième commutation entre l'état de commande d'ouverture et l'état de commande de fermeture, l'interrupteur passant à un état passant en un temps de fermeture à partir de la troisième commutation ; et
- le deuxième délai est inférieur au temps de fermeture.

Selon un mode de réalisation :
- ladite application de ladite commande est effectuée au moyen d'une liaison ayant une première impédance ; et
- lors de la mise en oeuvre de ladite application du potentiel de blocage, une deuxième impédance entre un noeud de fourniture dudit potentiel de blocage et ladite borne de commande est inférieure à la première impédance.

Un mode de réalisation prévoit un dispositif configuré pour mettre en oeuvre un procédé tel que défini ci-dessus, le dispositif comprenant un circuit de commande rapprochée configuré pour fournir la commande, et un circuit configuré pour :
- recevoir un signal représentatif de ladite commande ; et
- mettre en oeuvre l'étape b) à partir de ladite commande.

Selon un mode de réalisation, le dispositif comprend :
- un autre interrupteur reliant ladite borne de commande à un noeud de fourniture dudit potentiel de blocage ;
- un élément capacitif reliant ledit noeud de fourniture à une autre borne de commande dudit un autre interrupteur ; et
- un élément résistif et une diode, électriquement en parallèle entre ladite autre borne de commande et un noeud de réception d'un signal représentatif de ladite commande.

Selon un mode de réalisation, ledit noeud de fourniture est défini par une borne de conduction dudit un interrupteur.

Selon un mode de réalisation, le dispositif comprend un élément capacitif reliant une borne de conduction dudit un interrupteur audit noeud de fourniture, et une source de tension ayant deux bornes reliées à deux bornes de l'élément capacitif.

Selon un mode de réalisation, le dispositif comprend un inverseur configuré pour recevoir ladite commande, ledit noeud de réception étant défini par une sortie de l'inverseur.

Selon un mode de réalisation, le dispositif comprend un circuit configuré pour fournir ladite commande.

Un mode de réalisation prévoit un circuit destiné à être utilisé dans un dispositif tel que défini ci-dessus, ledit circuit étant configuré pour :
- recevoir un signal représentatif de ladite commande ; et
- mettre en oeuvre l'étape b) à partir de ladite commande, ledit circuit étant de préférence monolithique, et le dispositif comprenant en outre un autre circuit configuré pour mettre en oeuvre l'étape a).

Un mode de réalisation prévoit un autre circuit comprenant un circuit tel que défini ci-dessus et ledit un interrupteur.

Un mode de réalisation prévoit un convertisseur comprenant un dispositif tel que défini ci-dessus ou un circuit tel que défini ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière partielle et schématique, un exemple de convertisseur auquel s'appliquent les modes de réalisation décrits ;
la figure 2 représente très schématiquement des chronogrammes d'un exemple de commandes de trois interrupteurs du convertisseur de la figure 1 ;
la figure 3 représente schématiquement un mode de réalisation d'un dispositif de commande d'interrupteur et un interrupteur commandé par ce dispositif ;
la figure 4 représente, par des chronogrammes schématiques, une étape d'un mode de réalisation d'un procédé mis en oeuvre par le dispositif de la figure 3 ;
la figure 5 représente, par des chronogrammes schématiques, une autre étape du procédé ; et
la figure 6 représente schématiquement un autre mode de réalisation d'un dispositif de commande d'interrupteur et un interrupteur commandé par ce dispositif.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des convertisseurs ou des parties de convertisseur ne sont pas décrites ni représentées, les modes de réalisation décrits étant compatibles avec les convertisseurs usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

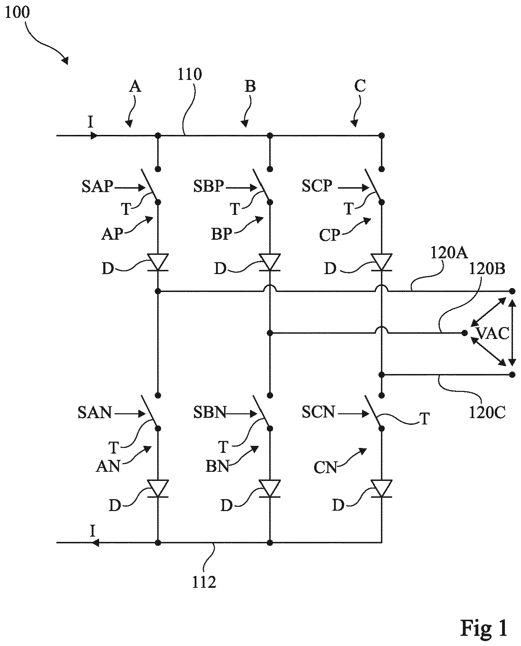

La figure 1 représente, de manière partielle et schématique, un exemple de convertisseur 100 auquel s'appliquent les modes de réalisation décrits. Le convertisseur 100 de cet exemple est de type onduleur à source de courant, CSI (de l'anglais "Current Source Inverter"). Cependant, cet exemple n'est pas limitatif, et les modes de réalisation décrits ci-après dans l'exemple d'un convertisseur de type CSI s'appliquent également à d'autres exemples de convertisseur CSI et à d'autres types de convertisseur. Ces autres types apparaîtront à l'homme du métier à la lumière des modes de réalisation décrits ci-après.

Dans cet exemple, la partie représentée du convertisseur 100 est alimentée par un courant I, de préférence continu, et fournit une tension alternative triphasée VAC. Le courant I peut provenir d'un élément inductif, non représenté, interne au convertisseur 100. La tension VAC peut être fournie aux bornes de condensateurs, non représentés, internes au convertisseur 100.

Le convertisseur 100 comprend des noeuds d'entrée 110 et 112. Dans l'exemple représenté, le courant d'alimentation I entre par le noeud 110 et sort par le noeud 112. Le convertisseur 100 comprend trois branches, respectivement A, B et C, électriquement en parallèle entre les noeuds 110 et 112. Chaque branche A, B, C comprend deux demi-branches, respectivement AP et AN, BP et BN, CP et CN. Dans chaque branche A, B, C, l'une des demi-branches relie le noeud 110 à un noeud 120 (120A, 120B, 120C), et l'autre des demi-branches relie les noeuds 112 et 120. Les demi-branches AP, BP et CP sont situées du côté du noeud 110, et les demi-branches AN, BN et CN sont situées du côté du noeud 112. Dans chaque branche A, B, C, les demi-branches sont ainsi connectées entre elles par les noeuds respectifs 120A, 120B, 120C. Les noeuds 120A, 120B, 120C constituent des noeuds de sortie entre lesquels le convertisseur fournit la tension triphasée VAC.

Chaque demi-branche comprend deux interrupteurs dont l'un au moins est commandé. Dans l'exemple représenté, chaque demi-branche comprend un interrupteur commandé T et, de préférence, une diode D définit un interrupteur non commandé. Chaque diode D a son anode tournée du côté du noeud 110 par lequel le courant I entre dans la partie représentée du convertisseur.

Les interrupteurs T peuvent être tout type d'interrupteur commandé adapté à former une cellule de commutation. De préférence, les interrupteurs T sont des transistors à effet de champ de type MOS à canal N. En variante, les transistors MOS sont à canal P. Dans d'autres variantes, les interrupteurs T sont du type transistor bipolaire ou du type transistor bipolaire à grille isolée, IGBT (en anglais "Isolated Gate Bipolar Transistor"). Chaque interrupteur T peut également comprendre plusieurs interrupteurs élémentaires électriquement en parallèle. De préférence, les interrupteurs élémentaires sont similaires ou identiques. Par identique, on entend ici identique à des tolérances de fabrication près. Les interrupteurs élémentaires peuvent être des transistors de type MOS (en variante, de type bipolaire). Les transistors d'un même interrupteur T ont alors leurs bornes de source (en variante, leurs bornes d'émetteur) connectées les unes aux autres et leurs bornes de drain (en variante, leurs bornes de collecteur) connectées les unes aux autres.

Dans chaque demi-branche AP, BP et CP, l'interrupteur T a une borne de conduction reliée, de préférence connectée, au noeud 110, et une autre borne de conduction reliée, par la diode D de la demi-branche considérée, au noeud 120 concerné. Par bornes de conduction d'un interrupteur, on entend les bornes de l'interrupteur entre lesquelles une connexion électrique est établie lorsque l'interrupteur est à l'état passant, par exemple les bornes de drain/source ou, en variante, de collecteur/émetteur. En variante, on peut échanger les positions de la diode D et du transistor T.

De préférence, chaque interrupteur T comprend une diode, non représentée, reliant les bornes de conduction de l'interrupteur T. Une telle diode est par exemple une diode dite diode intrinsèque (en anglais "body diode") définie par une jonction entre des régions semiconductrices de l'interrupteur T considéré. Cette diode a sa cathode tournée du côté du noeud 110 par lequel le courant I entre dans la partie représentée du convertisseur.

De préférence, chaque diode D est définie par une jonction entre des régions semiconductrices d'un interrupteur non représenté. Autrement dit, chaque diode D est la diode intrinsèque d'un interrupteur. Ces interrupteurs, appelés ici interrupteurs des diodes D, sont préférentiellement des transistors à effet de champ de type MOS à canal N, mais peuvent être de tout type de transistor comprenant une diode. En fonctionnement, l'interrupteur de chaque diode D est de préférence rendu passant aux moments où la diode doit laisser passer un courant, afin de réduire une perte d'énergie due à une chute de tension dans la diode à l'état passant. Le procédé de commande des interrupteurs de diode n'est pas décrit ici en détails, les modes de réalisation décrits étant compatibles avec les procédés usuels de commande d'interrupteurs de diode d'un convertisseur de type CSI.

En fonctionnement, dans chaque demi-branche AP, BP, CP, AN, BN, CN, l'interrupteur T est commandé par une commande respective SAP, SBP, SCP, SAN, SBN, SCN.

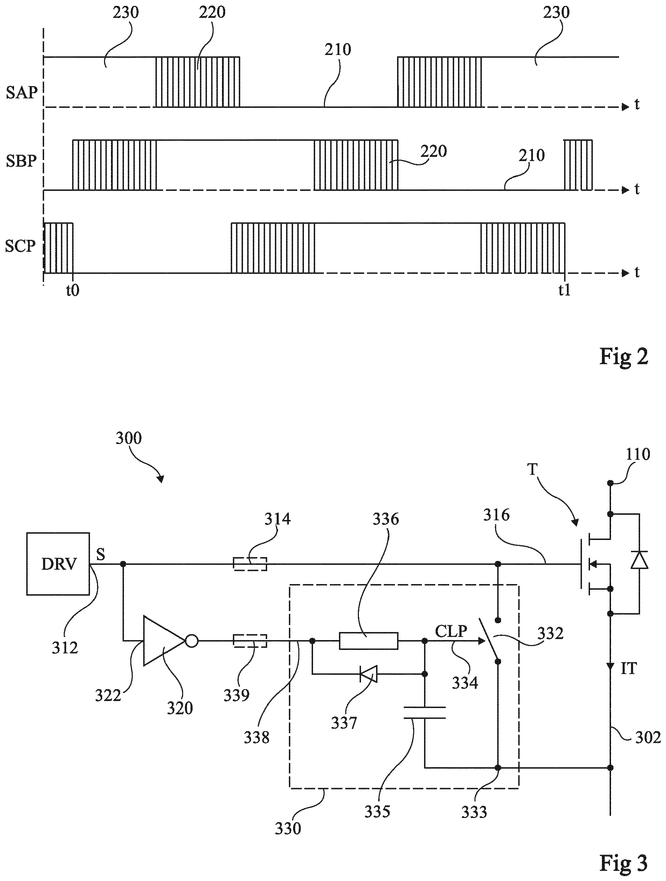

La figure 2 représente très schématiquement des chronogrammes d'un exemple de commandes SAP, SBP et SCP des interrupteurs AP, BP et CP du convertisseur de la figure 1 situés du côté du noeud 110 d'entrée du courant I. Plus précisément, on a représenté ici un exemple de cycle de commande entre des instants t0 et t1. Le cycle de commande est ici répété à la fréquence de la tension de sortie, par exemple 50 Hz ou 60 Hz. Le cycle de commande particulier représenté ici n'est pas limitatif, les modes de réalisation décrits étant applicables aux cycles de commande usuels des convertisseurs de type CSI. Les commandes SAN, SBN et SCN ne sont ni décrites, ni représentées, les modes de réalisation décrits étant compatibles avec les cycles de commande usuels des interrupteurs de demi-branches connectées à un noeud, tel que le noeud 112, par lequel sort le courant d'entrée d'un convertisseur de type CSI.

Chacune des commandes SAP, SBP et SCP présente un niveau bas et un niveau haut. Dans l'exemple représenté, le niveau bas est un niveau d'ouverture, ou état de commande d'ouverture, de l'interrupteur T. Par état de commande d'ouverture d'un interrupteur, on entend que l'application à cet interrupteur de la commande lorsqu'elle est à l'état de commande d'ouverture provoque le blocage, ou ouverture, de cet interrupteur. Dans l'exemple représenté, le niveau haut est un niveau de fermeture, ou état de commande de fermeture, de l'interrupteur T. Par état de commande de fermeture d'un interrupteur, on entend que l'application à cet interrupteur de la commande lorsqu'elle est à l'état de commande de fermeture provoque la mise à l'état passant, ou fermeture, de cet interrupteur. Ceci n'est pas limitatif, les niveaux bas et haut pouvant être échangés et commander respectivement la fermeture et l'ouverture de l'interrupteur T. Bien que chacun des niveaux bas et haut représentés ici ait une valeur constante ou quasiment constante en fonction du temps t, pour chacun des états de commande d'ouverture et de fermeture, la commande appliquée à la borne de commande de l'interrupteur T peut avoir un potentiel variant en fonction du temps. Dans un exemple, le niveau haut correspond environ au potentiel de l'une des bornes de conduction de l'interrupteur T, ici le potentiel du noeud 110 (figure 1), et le niveau bas correspond environ au potentiel de l'autre des bornes de conduction de l'interrupteur T, ici le potentiel du noeud 120 concerné.

Pour chacune des demi-branches, la commande est uniquement au niveau d'ouverture durant des périodes 210. Dans l'exemple représenté, chaque cycle comprend une période 210 pour chaque demi-branche. Dans l'exemple représenté, chaque période 210 a une durée égale à environ un tiers de la durée du cycle de commande, c'est-à-dire du temps de cycle de la tension alternative VAC fournie. L'interrupteur T et la demi-branche concernés sont alors dits inactifs pendant cette période. Les périodes d'inactivité 210 des demi-branches AP, BP et CP se succèdent cycliquement, par exemple dans cet ordre, la fin d'une période d'inactivité 210 de chaque demi-branche marquant le début, ou sensiblement le début, de la période d'inactivité 210 de la demi-branche suivante. Autrement dit, les interrupteurs T des demi-branches CP, AP et BP sont inactifs à tour de rôle.

Pour chacune des demi-branches, pendant des périodes 220, la commande présente des alternances (représentées par des hachures verticales) des niveaux d'ouverture et de fermeture de l'interrupteur T. Dans l'exemple représenté, chaque cycle présente deux périodes 220 pour chaque demi-branche. Dans cet exemple, la fin de l'une des périodes 220 marque le début, ou sensiblement le début, de la période d'inactivité 210 suivante, et la fin de la période d'inactivité 210 marque le début, ou sensiblement le début, de l'autre des périodes 220. Dans cet exemple, chaque période 220 a une durée d'environ un sixième de celle du cycle de commande.

Au cours de chaque période 220, chaque alternance correspond à un cycle de découpage de la commande, dans lequel la commande est successivement aux niveaux bas et haut. Les cycles de découpage sont répétés à une fréquence dite fréquence de découpage. A chaque cycle de découpage, un rapport cyclique est défini par le rapport entre la durée pendant laquelle la commande reste au niveau haut et la durée du cycle de découpage. De préférence, le rapport cyclique est variable et la fréquence de découpage est constante (modulation de largeur d'impulsion, MLI, en anglais PWM "Pulse Width Modulation"). En variante, la fréquence de découpage est, également, variable.

Pour chacune des demi-branches la commande est uniquement au niveau de fermeture durant des périodes 230. Dans l'exemple représenté, chaque cycle comprend une période 230 pour chaque demi-branche. Dans l'exemple représenté, chaque période 230 a une durée égale à environ un tiers de la durée du cycle de commande, les deux autres tiers du cycle de commande étant occupés par la période d'inactivité 210 et les périodes de découpage 220. Les périodes 230 des demi-branches AP, BP, et CP se succèdent à chaque cycle, par exemple dans cet ordre. Ainsi, les interrupteurs T des demi-branches AP, BP et CP ne sont jamais tous les trois en même temps à l'état bloqué. Au cours de chaque période 230, le courant I passe par la demi-branche AP, BP, CP concernée lorsque les autres des demi-branches AP, BP et CP ont leur interrupteur T à l'état bloqué. La demi-branche joue ainsi un rôle dit de roue libre, la période 230 étant dite période de roue-libre.

La figure 3 représente schématiquement un mode de réalisation d'un dispositif 300 de commande d'interrupteur et un interrupteur T, tel que défini ci-dessus, commandé par le dispositif 300. L'interrupteur T est par exemple celui de l'une des demi-branches du convertisseur de la figure 1. La commande S est alors constituée par la commande SAP, SBP, SCP, SAN, SBN, SCN, concernée, par exemple telle qu'illustrée dans l'exemple de la figure 2. De préférence, on prévoit un dispositif de commande tel que le dispositif 300 pour chacun des interrupteurs T des demi-branches du convertisseur de la figure 1.

L'interrupteur T, dans l'exemple représenté en figure 3, comprend un transistor de type MOS à canal N, comprenant une diode intrinsèque ayant sa cathode et son anode connectées respectivement au drain et à la source du transistor. Par exemple, le transistor a son drain relié, de préférence connecté, au noeud 110 (figure 1). Les modes de réalisation décrits s'appliquent à tous types d'interrupteurs adaptés à être utilisés dans un convertisseur, en particulier tels que ceux décrits en relation avec la figure 1.

Le dispositif 300 comprend un circuit DRV dit de commande rapprochée (en anglais "driver"), configuré pour fournir la commande S. Le circuit DRV peut être tout circuit usuel permettant de fournir une commande appliquée à une borne de commande d'interrupteur. Le circuit DRV fournit la commande S sur une sortie 312 reliée, par une liaison 314, à la borne de commande 316 de l'interrupteur T.

De préférence, le dispositif 300 comprend en outre un inverseur 320. L'inverseur 320 a une entrée 322 reliée, de préférence connectée, à la sortie 312 du circuit DRV. De préférence, l'inverseur 320 fournit un signal à un niveau haut (respectivement bas) lorsque l'inverseur reçoit un signal à un niveau bas (respectivement haut) sur son entrée 322. Les niveaux bas et haut peuvent avoir des tensions différentes en entrée et en sortie de l'inverseur 320. Autrement dit, l'inverseur peut réaliser une adaptation des niveaux de tension entre son entrée et sa sortie.

Le dispositif 300 comprend en outre un circuit 330. Le circuit 330 comprend un interrupteur 332, autre que l'interrupteur T, reliant la borne de commande 316 de l'interrupteur T à un noeud 333. Plus précisément, l'interrupteur 332 a ses bornes de conduction reliées, de préférence connectées, respectivement à la borne de commande 316 et au noeud 333. L'interrupteur 332 a une borne de commande 334. L'interrupteur 332 est de préférence un transistor de type MOS à canal N, cependant, l'interrupteur 332 peut être tout de tout type ayant un état passant où il établit une connexion électrique entre la borne 316 et le noeud 333 lorsqu'un signal de commande CLP appliqué sur sa borne de commande est à un premier niveau, par exemple un niveau haut. De préférence, lorsque le signal de commande CLP est à un deuxième niveau, par exemple un niveau bas, l'interrupteur 332 est à un état bloqué où il interrompt la connexion électrique entre la borne 316 et le noeud 333.

Le circuit 330 comprend en outre un élément capacitif 335 reliant le noeud 333 à la borne de commande 334 de l'interrupteur 332. L'élément capacitif 335 peut être formé d'un condensateur, tel que représenté, et/ou d'une capacité parasite de l'interrupteur 332 entre sa borne de commande 334 et sa borne de conduction connectée au noeud 333. Une telle capacité parasite est par exemple, dans le cas où l'interrupteur 332 est un transistor de type MOS à canal N, située entre la grille et la source du transistor. Le circuit 330 comprend en outre un élément résistif 336 et une diode 337, électriquement en parallèle entre la borne de commande 334 et un noeud 338. La diode 337 a son anode tournée du côté de la borne de commande 334. Le noeud 338 est relié, par une liaison 339, à la sortie de l'inverseur 320.

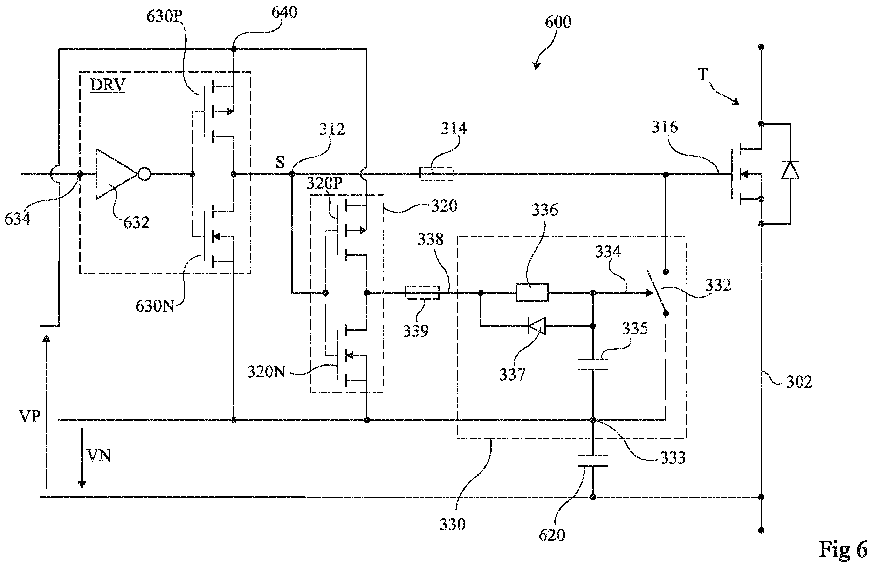

Selon le présent mode de réalisation, le noeud 333 est relié à une borne de conduction 302 de l'interrupteur T, ici à la source du transistor MOS constituant l'interrupteur T. De préférence, le noeud 333 et la borne 302 sont connectés, autrement dit, le noeud 333 et la borne 302 définissent un même noeud. Dans une variante, non représentée en figure 3, le noeud 333 et la borne 302 ne sont pas connectés directement, mais sont reliés par un élément de liaison, souhaitable ou parasite, tel qu'une résistance, une inductance et/ou un condensateur. Un exemple d'un tel élément de liaison sera décrit ci-après en relation avec la figure 6.

En fonctionnement, le noeud 338 reçoit un signal fourni par l'inverseur 320, inverse de la commande S. Lorsque l'interrupteur 332 est à l'état passant, le potentiel du noeud 333, à savoir celui de la borne de conduction 302 dans le présent mode de réalisation, est appliqué sur la borne de commande 316 de l'interrupteur T. Dans ce mode de réalisation, l'interrupteur T est de sorte que, lorsqu'une tension nulle ou sensiblement nulle est appliquée entre ses bornes 302 et 316, le transistor T est dans un état bloqué. Le circuit 330 bloque ainsi l'interrupteur T et empêche le passage d'un courant IT dans l'interrupteur T. Autrement dit, le potentiel du noeud 333 est un potentiel de blocage de l'interrupteur T.

Le blocage, ou verrouillage (en anglais "clamping"), de l'interrupteur T par le circuit 330 permet d'éviter que l'interrupteur T passe à l'état passant de manière intempestive lorsque la commande S est au niveau bas, suite par exemple à des parasites. Un tel passage à l'état passant risquerait, en particulier lorsque la demi-branche comprenant l'interrupteur T est dans une période d'inactivité 210, de mettre la sortie du convertisseur au moins en partie en court-circuit, ou risquerait d'avoir pour conséquence une tension non désirée en sortie du convertisseur. Un tel défaut réduirait le rendement du convertisseur, risquerait de réduire la fiabilité du convertisseur, risquerait d'endommager le convertisseur, voire risquerait d'endommager des éléments reliés au convertisseur. Des parasites se produisent notamment à cause des variations rapides de tension aux bornes de la demi-branche inactive, dues aux commutations dans les branches actives. Par exemple, les charges et décharges successives de capacités parasites de l'interrupteur T de la demi-branche inactive sont susceptibles d'engendrer, entre bornes de conduction et de commande de l'interrupteur T, des tensions suffisantes pour rendre l'interrupteur T au moins en partie passant.

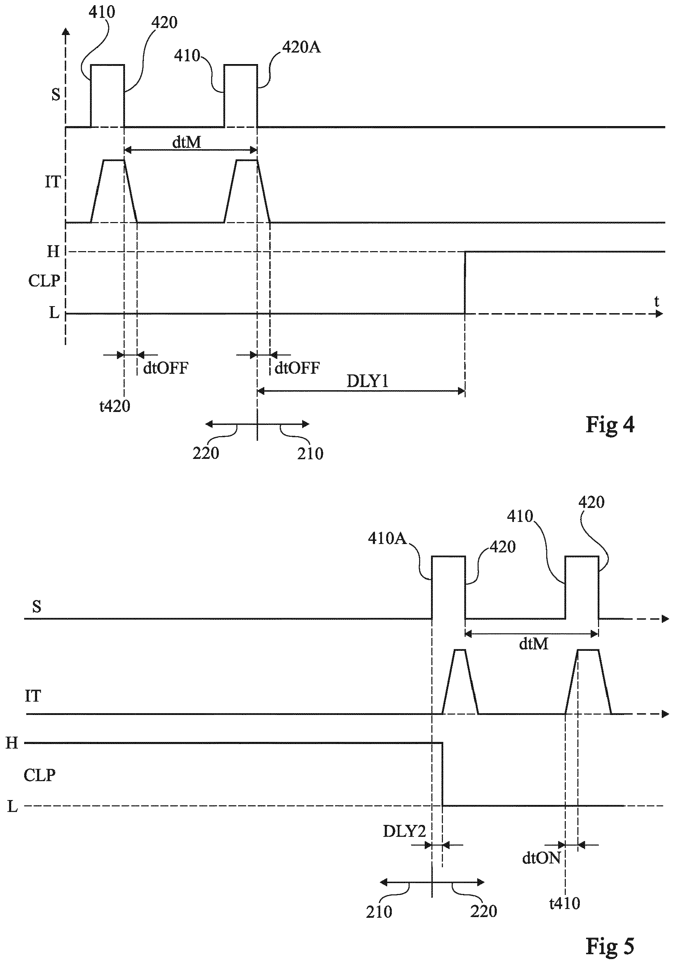

Les figures 4 et 5 représentent, par des chronogrammes schématiques, des étapes d'un mode de réalisation d'un procédé mis en oeuvre par le dispositif de la figure 3. Plus précisément, on a représenté, en fonction du temps t, la commande S, le courant IT dans l'interrupteur T, et deux niveaux H et L du signal de commande CLP commandant respectivement les états passant et non passant de l'interrupteur 332. Dans l'exemple représenté, le niveau H du signal de commande correspond aux valeurs de la commande CLP supérieures à un seuil de mise à l'état passant de l'interrupteur 332, et le niveau L correspond aux valeurs de la commande CLP inférieures à ce seuil. La commande S est ici du type des signaux SAP, SBP et SCP décrits ci-dessus en relation avec la figure 2.

Les chronogrammes de la figure 4 représentent la fin d'une période de découpage 220 et le début d'une période d'inactivité 210 pour l'interrupteur T. Comme mentionné ci-dessus, la commande S présente des créneaux pendant la période de découpage 220. Deux derniers créneaux de la période de découpage 220 sont représentés ici de manière très schématique.

Dans l'exemple représenté, la commande S présente, au début de chaque créneau, un front montant 410 entre le niveau d'ouverture (ici le niveau bas) et le niveau de fermeture (ici le niveau haut). La commande S présente, à la fin de chaque créneau, un front descendant 420 entre le niveau de fermeture et le niveau d'ouverture. Pendant au moins une partie de chaque créneau ici représenté, l'interrupteur T est passant et le courant IT passe dans l'interrupteur T.

Après chaque front descendant 420, l'interrupteur T passe à l'état bloqué. Cependant, en pratique, le courant dans l'interrupteur T ne s'interrompt pas immédiatement à l'instant t420 où le front 420 est fourni par le circuit DRV. En pratique, l'interrupteur T passe à l'état bloqué, c'est-à-dire annule le courant IT qui le traverse, en un temps d'ouverture dtOFF à partir de l'instant t420 où la commande S passe au niveau d'ouverture. Le temps d'ouverture dtOFF, est, par exemple, lié à une impédance de la liaison 314 (figure 3, impédance représentée en pointillés), par laquelle la commande S est appliquée à la borne de commande 316. Cette impédance est sensiblement équivalente à une résistance et une inductance en série entre le circuit DRV et la borne de commande 316 de l'interrupteur T. Le temps d'ouverture dtOFF est aussi lié aux impédances parasites telles que celles des demi-branches. Des oscillations amorties du courant, non représentées, peuvent encore se produire après l'écoulement du temps dtOFF, le temps dtOFF correspondant ainsi au temps entre l'instant t420 et l'instant de la première annulation du courant IT après l'instant t420.

Le circuit 330 applique le potentiel du noeud 333 à la borne de commande 316, c'est-à-dire verrouille l'interrupteur T, seulement après un délai DLY1 débutant à l'instant t420. En particulier, les valeurs de résistance de l'élément résistif 336, de capacité de l'élément capacitif 335, les niveaux de tension fournis par l'inverseur 320, et la tension de seuil de l'interrupteur 332 sont choisis pour obtenir le délai DLY1 souhaité. Le délai DLY1 est supérieur au temps d'ouverture dtOFF, autrement dit la durée du délai DLY1 est supérieure au temps d'ouverture dtOFF.

Afin d'éviter le plus possible la mise en conduction intempestive susmentionnée, on aurait pu être incité à utiliser, à la place de l'inverseur 320 et du circuit 330 du dispositif de la figure 3, un circuit permettant d'appliquer le potentiel de la borne de conduction 302 à la borne de commande 316 sans délai après le passage de la commande au niveau d'ouverture, ou avec un délai le plus faible possible. Cependant, par rapport à un tel circuit de verrouillage sans délai ou à délai le plus faible possible, le fait de prévoir le délai DLY1 permet de limiter ou d'éviter le risque que, dans une période active, c'est-à-dire une période de découpage 220 ou, plus particulièrement, dans une période de roue-libre 230, un parasite déclenche l'application du potentiel de la borne de conduction 302 à la borne de commande 316. Ceci provoquerait un blocage intempestif de l'interrupteur T et risquerait par exemple de mettre en circuit ouvert l'entrée du courant I dans le convertisseur 100, c'est-à-dire de bloquer tous les chemins de circulation du courant I dans le convertisseur. Un tel circuit ouvert réduirait le rendement du convertisseur, et risquerait de réduire la fiabilité du convertisseur, risquerait d'endommager le convertisseur, voire risquerait d'endommager des éléments reliés au convertisseur. En particulier, le fait de prévoir un délai DLY1 supérieur au temps d'ouverture dtOFF permet de réduire ces risques pour des parasites liés aux ouvertures des interrupteurs.

De préférence, comme ceci est représenté, le délai DLY1 est supérieur à un temps de cycle de découpage dtM, autrement dit un temps de cycle des alternances des périodes de découpage 220. Par exemple, le délai DLY1 est égal à 150 % du temps de cycle de découpage dtM. Ainsi, le circuit 330 ne verrouille pas l'interrupteur T au cours d'une période de découpage. Le verrouillage de l'interrupteur T se produit seulement après un front 420A qui, parmi les fronts 420, marque le début de la période d'inactivité 210. Ceci permet d'éviter tout risque de blocage intempestif de l'interrupteur T dans une période de découpage 220.

De préférence, le délai DLY1 est inférieur à 1 %, de préférence inférieur à 0,2 % plus préférentiellement inférieur à 0,05 % de la durée des périodes d'inactivité 210. Le délai DLY1 est de préférence inférieur à environ 100 ps, préférentiellement inférieur à 67 ps, plus préférentiellement inférieur à 13 ps, encore plus préférentiellement inférieur à environ 3,3 ps, par exemple égal à environ 3 ps. Ces valeurs du délai DLY1 sont plus particulièrement préférées pour une fréquence de la tension alternative égale à 50 Hz et un mode de commande tel que celui de la figure 2. Le délai DLY1 est plus préférentiellement égal à la plus petite des valeurs entre environ 3 µs et environ 150 % du temps de cycle dtM. Ce choix d'une valeur ainsi très inférieure à la durée de la période d'inactivité 210 est avantageux en particulier lorsque les variations de la tension aux bornes de la demi-branche inactive augmentent progressivement à partir du début de la période d'inactivité 210. Le délai DLY1 est ainsi, de préférence, de sorte que, pendant le délai DLY1, l'amplitude des variations de tension aux bornes de la demi-branche inactive reste suffisamment réduite pour ne pas provoquer de mise intempestive à l'état passant du transistor inactif T.

Les chronogrammes de la figure 5 représentent la fin d'une période d'inactivité 210 et le début d'une période de découpage 220 de l'interrupteur T. Deux premiers créneaux de la période de découpage 220 sont représentés ici de manière très schématique. La période d'inactivité 210 se termine à l'instant où un front 410A parmi les fronts 410 est généré par le circuit DRV.

Après le front 410A, l'application à la borne de commande 316 du potentiel du noeud 333 est interrompue après un délai DLY2. Autrement dit, l'interrupteur T est déverrouillé après le délai DLY2. Le délai DLY2 correspond au temps mis par le signal CLP pour atteindre son niveau L de commande de l'ouverture de l'interrupteur 332, par la décharge de l'élément capacitif 335 à travers la diode 337, en fonction du niveau de tension de sortie de l'inverseur 320. Le délai DLY2 est inférieur au délai DLY1, autrement dit, la durée du délai DLY2 est inférieure à celle du délai DLY1.

Une fois que l'interrupteur T est déverrouillé, l'interrupteur T peut devenir passant. Ainsi, après chaque front montant 410 situé en dehors des périodes d'application du potentiel du noeud 333 à la borne de commande 316, l'interrupteur T passe à l'état passant. Cependant, en pratique, l'interrupteur T n'est pas immédiatement passant dès l'instant t410 où le front 410 est fourni par le circuit DRV. En pratique, l'interrupteur T passe à l'état passant, c'est-à-dire permet le passage de la totalité du courant d'entrée I, en un temps de fermeture dtON à partir de l'instant t410 où la commande passe au niveau de fermeture. Le courant peut présenter des oscillations après le temps dtON. Le temps dtON correspond alors au temps entre l'instant t410 et l'instant de la première fois que le courant IT passe par la valeur du courant I après l'instant t410.

De préférence, le délai DLY2 est inférieur au temps de fermeture dtON, préférentiellement inférieur à 2 % du temps de cycle de découpage dtM, plus préférentiellement inférieur à 0,8 %, encore plus préférentiellement inférieur à 0,2 % du temps de cycle de découpage dtM. De préférence, le délai DLY2 est inférieur à environ 1 ps, plus préférentiellement inférieur à 400 ns, encore plus préférentiellement inférieur à 100 ns, par exemple de l'ordre de 30 ns. Ces valeurs du délai DLY2 sont plus particulièrement préférées pour une fréquence de découpage de 50 kHz, c'est-à-dire un temps de cycle de découpage de 20 ps. Ceci permet de démarrer le découpage sensiblement dès le début du premier créneau de la période de découpage 220. On évite en particulier que l'interrupteur T reste bloqué au cours d'un ou plusieurs des créneaux de début de la période de découpage 220, ce qui nuirait à la qualité de la tension fournie par le convertisseur.

De préférence, le délai DLY2 est supérieur à 0,01 % du temps de cycle de découpage dtM, préférentiellement supérieur à 0,05 % du temps de cycle de découpage dtM, encore plus préférentiellement supérieur à 0,1 % du temps de cycle de découpage dtM. Ainsi, le délai DLY2 est préférentiellement compris entre 0,01 % et 2 % du temps de cycle de découpage dtM. De préférence, le délai DLY2 est supérieur à 2 ns, préférentiellement supérieur à 10 ns, plus préférentiellement supérieur à 20 ns, par exemple de l'ordre de 20 ns. Ces valeurs du délai DLY2 sont plus particulièrement préférées pour une fréquence de découpage de 50 kHz, c'est-à-dire un temps de cycle de découpage de 20 ps. Ceci peut être obtenu, par exemple, par une résistance en série avec la diode 337 (figure 3), ou encore, par exemple, par le choix de la diode 337. Ceci permet de filtrer d'éventuels parasites et d'éviter que l'application du potentiel de blocage soit interrompue momentanément au cours des périodes d'inactivité 210. Dans une variante, le délai DLY2 peut même être supérieur au temps de fermeture dtON.

On a décrit ci-dessus un mode de réalisation particulier d'un dispositif 300 configuré pour mettre en oeuvre le procédé des figures 4 et 5. Ce mode de réalisation n'est pas limitatif.

Ainsi, on peut remplacer l'inverseur 320 par tout circuit configuré pour recevoir la commande S et fournir un signal représentatif de la commande S sur sa sortie. L'homme du métier est en mesure d'adapter le circuit 330 de la figure 3 pour appliquer un potentiel de blocage de la manière décrite ci-dessus en relation avec les figures 4 et 5 à partir du signal représentatif de la commande S. Ce signal représentatif est alors reçu par le circuit 330 ainsi adapté, sur un noeud d'entrée tel que le noeud 338, qui définit ainsi un noeud de réception du signal représentatif de la commande S. En particulier, dans une variante, l'inverseur 320 est omis.

On peut donc, dans le dispositif 300, remplacer le circuit 330 par tout circuit adapté à appliquer un potentiel de blocage d'une manière similaire ou identique à celle décrite ci-dessus, à partir d'un signal représentatif de la commande S.

Cependant, le circuit 330 de la figure 3 présente l'avantage d'être particulièrement simple, c'est-à-dire plus simple que les circuits usuels constituant le circuit DRV. Ceci permet de placer facilement le circuit 330 à proximité de l'interrupteur T. Par proximité, on entend ici que lorsque le l'interrupteur 332 est passant, l'impédance entre le noeud 333 de fourniture du potentiel de blocage et la borne de commande 316 est inférieure à l'impédance de la liaison 314, de préférence inférieure à 0,1 fois l'impédance de la liaison 314. Autrement dit, le circuit 330 est plus proche de l'interrupteur T que le circuit DRV. Par rapport à une variante dans laquelle le circuit 330 n'est pas plus proche que le circuit DRV, ceci permet de limiter le risque que des parasites déverrouillent momentanément l'interrupteur T. Ceci est plus particulièrement avantageux lorsque l'interrupteur T comprend plusieurs interrupteurs en parallèle. Un circuit identique ou similaire au circuit 330 peut alors être placé au plus près de chaque interrupteur composant l'interrupteur T, ces circuits recevant tous la même commande S sur un noeud 338 commun.

En outre, l'élément résistif 336 et l'élément capacitif 335 constituent un filtre passe-bas. De ce fait, on peut prévoir que la liaison 339 entre l'inverseur 320 (ou un autre circuit de fourniture d'un signal représentatif de la commande S) et le circuit 330 ait une impédance (représentée en pointillés en figure 3), supérieure à l'impédance entre le noeud 333 et la borne 316 lorsque l'interrupteur 332 est passant. Le fait de prévoir une telle impédance de la liaison 339 permet de faciliter le positionnement de l'inverseur 320 dans le dispositif.

Selon un mode de réalisation, le circuit 330 est monolithique, c'est-à-dire que les éléments du circuit 330 sont tous situés dans une même puce électronique de circuit intégré. Une telle puce (en anglais "die") est définie par une portion de tranche (en anglais "wafer") semiconductrice et des circuits électroniques situés dans et sur la tranche. La puce est de préférence située dans un boîtier de circuit intégré. Un tel boîtier est défini par un boîtier de préférence étanche contenant la puce, et comprenant des plages de connexion et/ou des broches conductrices. Les plages et/ou broches sont reliées, de préférence connectées, électriquement à la puce et destinées à être reliées, de préférence connectées, électriquement à d'autres circuits. De préférence, les plages et/ou broches sont destinées à être soudées sur une plaque de circuit imprimé PCB (en anglais "Printed Circuit Board"). Plus préférentiellement, l'ensemble du circuit 330 et de l'interrupteur T est monolithique.

La figure 6 représente schématiquement un autre mode de réalisation d'un dispositif 600 de commande d'interrupteur et un interrupteur T commandé par le dispositif 600.

Le dispositif 600 comprend des éléments identiques ou similaires à ceux du dispositif 300 de la figure 3, agencés de manière identique ou similaire. Seules les différences sont mises en exergue ci-après. Le dispositif 600 diffère du dispositif 300 de la figure 3 principalement en ce que le noeud 333 de fourniture du potentiel de blocage n'est pas connecté directement à la borne de conduction 302 de l'interrupteur T, et qu'un élément capacitif 620, de préférence un condensateur, relie le noeud 333 à la borne de conduction 302. Une source de tension a deux bornes reliées respectivement à la borne 302 et au noeud 333, c'est-à-dire aux bornes de l'élément capacitif 620, et applique une tension VN entre la borne 302 et le noeud 333. Dans l'exemple représenté où l'interrupteur T est un transistor de type MOS à canal N et où la borne 302 est la source du transistor, la tension VN est positive, ce qui permet d'obtenir, sur le noeud 333, un potentiel de blocage du transistor inférieur au potentiel de la source du transistor.

Dans l'exemple représenté, le circuit DRV comprend un transistor de type MOS à canal P 630P et un transistor de type MOS à canal N 630N montés en inverseur. Autrement dit, les grilles des transistors 630P et 630N sont reliées, de préférence connectées, l'une à l'autre, et les drains des transistors 630P et 630N sont reliés, de préférence connectés, l'un à l'autre. Les grilles des transistors 630P et 630N sont reliées, de préférence connectées, à une sortie d'un inverseur 632 ayant une entrée 634. L'entrée 634 constitue une entrée du circuit DRV. Les drains des transistors 630P et 630N sont reliés, de préférence connectés, à la sortie 312 du circuit DRV. En fonctionnement, la commande S fournie par le circuit DRV est fonction d'un signal appliqué sur l'entrée 634.

Dans l'exemple représenté, l'inverseur 320 comprend un transistor de type MOS à canal P 320P et un transistor de type MOS à canal N 320N montés en inverseur. Autrement dit, les grilles des transistors 320P et 320N sont reliées, de préférence connectées, l'une à l'autre, et les drains des transistors 320P et 320N sont reliés, de préférence connectés, l'un à l'autre. Les grilles des transistors 320P et 320N sont reliées, de préférence connectées, à la sortie 312 du circuit DRV.

Dans l'exemple représenté, les sources des transistors 320P et 630P sont reliées, de préférence connectées, à un noeud 640. Les sources des transistors 320N et 630N sont reliées, de préférence connectées, au noeud 333 d'application du potentiel de blocage. Une source de tension applique une tension VP entre le noeud 640 et la borne 302. Autrement dit, le circuit DRV et l'inverseur 320 sont alimentés en parallèle entre les noeuds 640 et 333 par une tension égale à la somme des tensions VP et VN.

Le dispositif 600 ainsi obtenu permet avantageusement à la commande S d'être bipolaire, c'est-à-dire que le niveau d'ouverture présenté par la commande S est un niveau de potentiel différent de celui de la source du transistor formant l'interrupteur T. Dans l'exemple représenté, où l'interrupteur T comprend un transistor de type MOS à canal N, le niveau, présenté par la commande S, d'ouverture de l'interrupteur T est un niveau de potentiel inférieur à celui de la source de ce transistor MOS à canal N. Par rapport à des procédés connus de commande d'un interrupteur, ce mode de fonctionnement permet d'améliorer la fiabilité du convertisseur.

Bien que l'on ait décrit ci-dessus, en relation avec la figure 6, une manière particulière d'alimenter le circuit DRV et l'inverseur 320, l'inverseur 320 des modes de réalisation des figures 3 et 6 ainsi que le circuit DRV du mode de réalisation de la figure 6 sont compatibles avec tout circuit d'alimentation d'un tel circuit DRV et/ou d'un inverseur. En particulier l'inverseur 320 peut être alimenté par une source d'alimentation différente de celle qui alimente le circuit DRV. Par exemple, dans une variante du mode de réalisation de la figure 6, la source du transistor 320P peut être reliée au noeud 640 par un circuit effectuant une adaptation de potentiel, et/ou la source du transistor 320N et/ou la source du transistor 630N peut être reliée au noeud 333 par un circuit effectuant une adaptation de potentiel. Un tel circuit d'adaptation de potentiel peut comprendre une diode de type Zener et une résistance en série, ou, par exemple, un régulateur de tension linéaire, par exemple de type à faible perte de niveau, LDO (en anglais "Low Drop-Out") .

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

En particulier, les modes de réalisation ne se limitent pas aux exemples décrits ci-dessus de fronts montants et descendants de la commande S correspondant à des commutations sensiblement instantanées ou quasi instantanées par rapport aux temps dtON et dtOFF, de préférence entre des niveaux restant constants ou sensiblement constants entre les fronts. Les modes de réalisation décrits sont applicables à tout type de commutation entre états de commande d'ouverture et de fermeture de l'interrupteur T et/ou entre états de commande de fermeture et d'ouverture de l'interrupteur T. En particulier, à chaque commutation, le signal de commande peut marquer une ou plusieurs pauses successives à des valeurs intermédiaires séparées par des fronts sensiblement instantanés. En pareil cas, on appelle instant de la commutation entre états de la commande S l'instant auquel la commande S franchit, dans le sens montant ou descendant, un niveau seuil. Le niveau seuil définit une séparation entre des niveaux de la commande S qui commandent des états définis comme bloqués et des niveaux de la commande S qui commandent des états définis comme passants. A titre d'exemple, dans le cas où l'interrupteur T comprend un transistor à effet de champ, le niveau seuil correspond à la tension de seuil du transistor, c'est-à-dire la tension entre grille et source pour laquelle un canal de conduction apparaît entre drain et source.

En outre, bien que les modes de réalisation décrits ci-dessus aient été décrits dans leur application à un convertisseur de type CSI, des modes de réalisation s'appliquent à tout convertisseur, préférentiellement aux convertisseurs dans lesquels des interrupteurs sont inactifs pendant une période d'inactivité ayant une durée de plusieurs fois un temps de cycle de découpage, préférentiellement de plus de 10 fois le temps de cycle de découpage, encore plus préférentiellement de plus de 100 fois le temps de cycle de découpage. Ainsi, le convertisseur peut être par exemple :
un onduleur à source de tension, VSI (de l'anglais "Voltage Source Inverter") ;
un onduleur multiniveaux à point neutre connecté par diodes, appelé NPC (de l'anglais "Neutral Point Clamped" - bloqué au point neutre) ;
un onduleur multiniveaux à point neutre connecté par transistors, appelé ANPC (de l'anglais "Active Neutral Point Clamped" - bloqué activement au point neutre) ; ou
un onduleur multiniveaux à point neutre connecté par interrupteur bidirectionnel, appelé T-Type (de l'anglais "T-type" - de type T).
Plus précisément, dans ces convertisseurs, le procédé de commande s'applique préférentiellement à l'un ou plusieurs interrupteurs ayant des périodes de découpage et des périodes d'inactivité du type de celles décrites ci-dessus en relation avec la figure 2.

Enfin, la mise en oeuvre pratique des modes de réalisation et variantes décrits est à la portée de l'homme du métier à partir des indications fonctionnelles données ci-dessus.

## Revendications

1. Procédé de commande d'un interrupteur (T), comprenant :
a) une application d'une commande (S) à une borne de commande (316) de l'interrupteur, ladite commande présentant au moins une première commutation (420A) entre un état de commande de fermeture de l'interrupteur et un état de commande d'ouverture de l'interrupteur, l'interrupteur passant à un état bloqué en un temps d'ouverture (dtOFF) à partir de la première commutation ; et
b) une application d'un potentiel de blocage de l'interrupteur sur ladite borne de commande après un premier délai (DLY1) débutant à ladite première commutation, le premier délai étant supérieur au temps d'ouverture (dtOFF), dans lequel :
- la première commutation (420A) marque le début d'une première période (210) à laquelle ladite commande est uniquement à l'état de commande d'ouverture ;
- une deuxième période (220) comprend des alternances des états de commande d'ouverture et de fermeture de l'interrupteur (T) ;
**caractérisé en ce que**
le premier délai est supérieur à un temps de cycle (dtM) des alternances.

2. Procédé selon la revendication 1, dans lequel la première commutation constitue un front entre un niveau de fermeture et un niveau d'ouverture.

3. Procédé selon la revendication 1 ou 2, dans lequel le premier délai (DLY1) est inférieur à 1 % d'une durée de la première période (210), de préférence inférieur à 0,2 % d'une durée de la première période, plus préférentiellement inférieur à 0,05 % de la première période.

4. Procédé selon l'une quelconque des revendications 1 à 3, dans lequel :
- ladite commande (S) présente, lors de ladite application du potentiel de blocage, au moins une deuxième commutation (410A) entre l'état de commande d'ouverture et l'état de commande de fermeture ; et
- ladite application du potentiel de blocage est interrompue dans un deuxième délai (DLY2) débutant à ladite deuxième commutation et inférieur au premier délai (DLY1), le deuxième délai étant de préférence inférieur à environ 1 ps.

5. Procédé selon la revendication 4, dans lequel :
- ladite commande (S) présente, en dehors de ladite application du potentiel de blocage, une troisième commutation (410) entre l'état de commande d'ouverture et l'état de commande de fermeture, l'interrupteur (T) passant à un état passant en un temps de fermeture (dtON) à partir de la troisième commutation ; et
- le deuxième délai (DLY2) est inférieur au temps de fermeture.

6. Procédé selon l'une quelconque des revendications 1 à 5, dans lequel :
- ladite application de ladite commande (S) est effectuée au moyen d'une liaison (314) ayant une première impédance ; et
- lors de la mise en oeuvre de ladite application du potentiel de blocage, une deuxième impédance entre un noeud de fourniture (333) dudit potentiel de blocage et ladite borne de commande (316) est inférieure à la première impédance.

7. Dispositif (300 ; 600) de commande d'interrupteur configuré pour mettre en oeuvre un procédé selon l'une quelconque des revendications 1 à 6, le dispositif comprenant un circuit de commande rapprochée (DRV) configuré pour fournir la commande (S), et un circuit (330) configuré pour :
- recevoir un signal représentatif de ladite commande (S) ; et
- mettre en oeuvre l'étape b) à partir de ladite commande.

8. Dispositif (300 ; 600) selon la revendication 7, comprenant :
- un autre interrupteur (332) reliant ladite borne de commande (316) à un noeud de fourniture dudit potentiel de blocage (333) ;
- un élément capacitif (335) reliant ledit noeud de fourniture (333) à une autre borne de commande (334) dudit un autre interrupteur (332) ; et
- un élément résistif (336) et une diode (337), électriquement en parallèle entre ladite autre borne de commande (334) et un noeud de réception (338) d'un signal représentatif de ladite commande (S).

9. Dispositif (300) selon la revendication 8, dans lequel ledit noeud de fourniture (333) est défini par une borne de conduction (302) dudit un interrupteur (T).

10. Dispositif (600) selon la revendication 8, comprenant un élément capacitif (620) reliant une borne de conduction (302) dudit un interrupteur (T) audit noeud de fourniture (333), et une source de tension (VN) ayant deux bornes reliées à deux bornes de l'élément capacitif.

11. Dispositif selon l'une quelconque des revendications 8 à 10, comprenant un inverseur (320) configuré pour recevoir ladite commande (S), ledit noeud de réception (338) étant défini par une sortie de l'inverseur.

12. Circuit (330) destiné à être utilisé dans un dispositif (300 ; 600) selon l'une quelconque des revendications 7 à 11, ledit circuit étant configuré pour :
- recevoir un signal représentatif de ladite commande (S) ; et
- mettre en oeuvre l'étape b) à partir de ladite commande, ledit circuit (330) étant de préférence monolithique, et le dispositif (300 ; 600) comprenant en outre le circuit de commande rapprochée (DRV) configuré pour mettre en oeuvre l'étape a).

13. Circuit comprenant un circuit (330) selon la revendication 12 et ledit un interrupteur (T).

14. Convertisseur comprenant un dispositif selon l'une quelconque des revendications 7 à 11 ou un circuit selon la revendication 12 ou 13.

## Patentansprüche

1. Verfahren zum Steuern eines Schalters (T), wobei das Verfahren Folgendes aufweist:
a) Anlegen eines Steuersignals (S) an einen Steueranschluss (316) des Schalters, wobei das Steuersignal mindestens eine erste Umschaltung (420A) zwischen einem Geschlossen-Steuerzustand des Schalters und einem Offen-Steuerzustand des Schalters vorsieht, wobei der Schalter innerhalb einer Offen-Zeit (dtOFF) ab der ersten Umschaltung in einen Blockierzustand übergeht; und
b) Anlegen eines Schalter-Blockierpotentials an den Steueranschluss nach einer ersten Verzögerung (DLY1), die bei dem ersten Schalten beginnt, wobei die erste Verzögerung länger als die Offen-Zeit (dtOFF) ist, wobei:
- das erste Schalten (420A) den Beginn einer ersten Periode (210) markiert, während der das Steuersignal nur im Offen-Steuerzustand ist;
- eine zweite Periode (220) Änderungen der Steuerzustände Offen und Geschlossen des Schalters (T) aufweist; **dadurch gekennzeichnet, dass** die erste Verzögerung länger als eine Zykluszeit (dtM) der Änderungen ist.

2. Verfahren nach Anspruch 1, wobei die erste Schaltung eine Flanke zwischen einem Geschlossenpegel und einem Offenpegel bildet.

3. Verfahren nach Anspruch 1 oder 2, wobei die erste Verzögerung (DLY1) kürzer ist als 1 % einer Dauer der ersten Periode (210), vorzugsweise kürzer als 0,2 % einer Dauer der ersten Periode, besonders bevorzugt kürzer als 0,05 % der ersten Periode.

4. Verfahren nach einem der Ansprüche 1 bis 3, wobei:
- das Steuersignal (S) während des Anlegens des Blockierpotentials mindestens eine zweite Umschaltung (410A) zwischen dem Offen-Steuerzustand und dem Geschlossen-Steuerzustand vorsieht; und
- das Anlegen des Blockierpotentials während einer zweiten Verzögerung (DLY2) unterbrochen wird, die bei dem zweiten Umschalten beginnt und kürzer als die erste Verzögerung (DLY1) ist, wobei die zweite Verzögerung vorzugsweise kürzer als etwa 1 µs ist.

5. Verfahren nach Anspruch 4, wobei:
- das Steuersignal (S) außerhalb des Anlegens des Blockierpotentials eine dritte Umschaltung (410) zwischen dem Offen-Steuerzustand und dem Geschlossen-Steuerzustand aufweist, wobei der Schalter (T) innerhalb einer Geschlossen-Zeit (dtON) ab der dritten Umschaltung in einen Durchlasszustand übergeht; und
- die zweite Verzögerung (DLY2) kürzer ist als die Geschlossen-Zeit.

6. Verfahren nach einem der Ansprüche 1 bis 5, wobei:
- das Anlegen des Steuersignals (S) mittels einer Verbindung (314) mit einer ersten Impedanz durchgeführt wird; und
- während der Durchführung des Anlegens des Blockierpotentials eine zweite Impedanz zwischen einem Knoten (333) zum Liefern des Blockierpotentials und dem Steueranschluss (316) kleiner ist als die erste Impedanz.

7. Schalter-Steuervorrichtung (300; 600), die konfiguriert ist zum Implementieren eines Verfahrens nach einem der Ansprüche 1 bis 6, wobei die Vorrichtung eine Treiberschaltung (DRV) aufweist, die konfiguriert ist zum Vorsehen des Steuersignals (S), und eine Schaltung (330), die konfiguriert ist zum:
- Empfangen eines für das Steuersignal (S) repräsentativen Signals; und
- Implementieren des Schritts b) basierend auf dem Steuersignal.

8. Vorrichtung (300; 600) nach Anspruch 7, aufweisend:
- einen weiteren Schalter (332), der den Steueranschluss (316) mit einem Knotenpunkt zum Liefern des Blockierpotentials (333) koppelt;
- ein kapazitives Element (335), das den Lieferknoten (333) mit einem anderen Steueranschluss (334) des weiteren Schalters (332) koppelt; und
- ein Widerstandselement (336) und eine Diode (337), die elektrisch parallel zwischen dem anderen Steueranschluss (334) und einem Knotenpunkt für den Empfang (338) eines für die Steuerung (S) repräsentativen Signals geschaltet sind.

9. Vorrichtung (300) nach Anspruch 8, wobei der Lieferknoten (333) durch einen Leitungsanschluss (302) des einen Schalters (T) definiert ist.

10. Vorrichtung (600) nach Anspruch 8, aufweisend ein kapazitives Element (620), das einen Leitungsanschluss (302) des einen Schalters (T) mit dem Lieferknoten (333) koppelt, und eine Spannungsquelle (VN), mit zwei Anschlüssen, die mit zwei Anschlüssen des kapazitiven Elements gekoppelt sind.

11. Vorrichtung nach einem der Ansprüche 8 bis 10, aufweisend einen Wechselrichter (320), der konfiguriert ist zum Empfangen des Steuersignals (S), wobei der Empfangsknoten (338) durch einen Ausgang des Wechselrichters definiert ist.

12. Schaltung (330), die zur Verwendung in einer Vorrichtung (300; 600) nach einem der Ansprüche 7 bis 11 vorgesehen ist, wobei die Schaltung konfiguriert ist zum:
- Empfangen eines für das Steuersignal (S) repräsentativen Signals;
- Implementieren von Schritt b) basierend auf dem Steuersignal,
- wobei die Schaltung (330) vorzugsweise monolithisch ist und die Vorrichtung (300; 600) ferner die Treiberschaltung (DRV) aufweist, die konfiguriert ist zum implementieren des Schritts a).

13. Schaltung aufweisend einer Schaltung (330) nach Anspruch 12 und den einen Schalter (T).

14. Wandler aufweisend eine Vorrichtung nach einem der Ansprüche 7 bis 11 oder einer Schaltung nach Anspruch 12 oder 13.

## Claims

1. Method of controlling a switch (T), comprising:
a) an application of a control signal (S) to a control terminal (316) of the switch, said control signal exhibiting at least one first switching (420A) between a switch turn-on control state and a switch turn-off control state, the switch switching to an off state within a turn-off time (dtOFF) from the first switching; and
b) an application of a switch turn-off potential on said control terminal after a first delay (DLY1) starting at said first switching, the first delay being longer than the turn-off time (dtOFF), wherein:
- the first switching (420A) marks the beginning of a first period (210) during which said control signal is only in the turn-off control state;
- a second period (220) comprises alternations of states of control of the turning on and the turning off of the switch (T); **characterised in that** the first delay is longer than a cycle time (dtM) of the alternations.

2. Method according to claim 1, wherein the first switching forms an edge between a turn-on level and a turn-off level.

3. Method according to claim 1 or 2, wherein the first delay (DLY1) is shorter than 1% of a duration of the first period (210), preferably shorter than 0.2% of a duration of the first period, more preferably shorter than 0.05% of the first period.

4. Method according to any of claims 1 to 3, wherein:
- said control signal (S) exhibits, during said application of the turn-off potential, at last one second switching (410A) between the turn-off control state and the turn-on control state; and
- said application of the turn-off potential is interrupted in a second delay (DLY2) starting at said second switching and shorter than the first delay (DLY1), the second delay preferably being shorter than approximately 1 ps.

5. Method according to claim 4, wherein:
- said control signal (S) has, outside of said application of the turn-off potential, a third switching (410) between the turn-off control state and the turn-on control state, the switch (T) switching to an on state within a turn-on time (dtON) from the third switching; and
- the second delay (DLY2) is shorter than the turn-on time.

6. Method according to any of claims 1 to 5, wherein:
- said application of said control signal (S) is performed by means of a link (314) having a first impedance; and
- during the implementation of said application of the turn-off potential, a second impedance between a node (333) for delivering said turn-off potential and said control terminal (316) is smaller than the first impedance.

7. A switch control device (300; 600) configured to implement a method according to any of claims 1 to 6, the device comprising a driver circuit (DRV) configured to provide the control signal (S), and a circuit (330) configured to:
- receive a signal representative of said control signal (S); and
- implement the step b) based on said control signal.

8. Device (300; 600) according to claim 7, comprising:
- another switch (332) coupling said control terminal (316) to a node for delivering said turn-off potential (333);
- a capacitive element (335) coupling said delivery node (333) to another control terminal (334) of said another switch (332); and
- a resistive element (336) and a diode (337) electrically in parallel between said other control terminal (334) and a node of reception (338) of a signal representative of said control (S).

9. Device (300) according to claim 8, wherein said delivery node (333) is defined by a conduction terminal (302) of said one switch (T).

10. Device (600) according to claim 8, comprising a capacitive element (620) coupling a conduction terminal (302) of said one switch (T) to said delivery node (333), and a voltage source (VN) having two terminals coupled to two terminals of the capacitive element.

11. Device according to any of claims 8 to 10, comprising an inverter (320) configured to receive said control signal (S), said reception node (338) being defined by an output of the inverter.

12. Circuit (330) intended to be used in a device (300; 600) according to any of claims 7 to 11, said circuit being configured to:
- receive a signal representative of said control signal (S) ;
- implement step b) based on said control signal,
- said circuit (330) being preferably monolithic, and the device (300; 600) further comprising the driver circuit (DRV) configured to implement step a).

13. Circuit comprising a circuit (330) according to claim 12 and said one switch (T).

14. Converter comprising a device according to any of claims 7 to 11 or a circuit according to claim 12 or 13.
